# EUROPEAN PATENT APPLICATION

(11) **EP 4 827 311 A1**
(43) Date of publication of application: **21.10.2026**
(21) Application number: 26169840.1
(22) Date of filing: 31.03.2026
(51) Int. Cl.: H10W 74/10, H10W 42/00, H10W 40/25, H10W 74/01, H10W 90/00

(54) **POWER MODULE, POWER CONVERSION DEVICE, AND LEAD FRAME**

(30) Priority: 02.04.2025 CN 202520615995 U
(71) Applicant: HUAWEI TECHNOLOGIES CO., LTD., Shenzhen 518129 (CN)
(72) Inventor: CHI, Panwang, Shenzhen, 518129 (CN); SUN, Tingting, Shenzhen, 518129 (CN); WANG, Zhaoyue, Shenzhen, 518129 (CN); CHEN, Huibin, Shenzhen, 518129 (CN); ZHOU, Sizhan, Shenzhen, 518129 (CN); LIU, Zhiling, Shenzhen, 518129 (CN)
(74) Representative: Isarpatent

(57) **Abstract**

This application relates to the field of power electronics technologies, and in particular, to a power module, a power conversion device, and a lead frame. The power module includes a substrate, an electronic element, and at least one mechanical part, the substrate includes a ceramic baseplate, and a first metal layer and a second metal layer that are disposed on two surfaces of the ceramic baseplate, both the electronic element and each mechanical part are disposed on a surface that is of the first metal layer and that is away from the ceramic baseplate, and brittleness of the mechanical part is less than brittleness of the ceramic baseplate. **In** a direction perpendicular to the substrate, an orthographic projection of any mechanical part on the first metal layer does not overlap with an orthographic projection of the electronic element on the first metal layer. Each mechanical part is used for being pressed against by an ejector pin of a mold in an injection molding packaging process. In an injection molding process, the power module can reduce a possibility of an undetectable micro crack generated in the ceramic baseplate under force, thereby improving product reliability, and helping improve production yield of the power module.

## Description

### TECHNICAL FIELD

This application relates to the field of power electronics technologies, and in particular, to a power module, a power conversion device, and a lead frame.

### BACKGROUND

Packaging may be used to install an integrated circuit, a discrete element, or another electronic component in a specific housing, and provide functions such as electrical connection, physical protection, and heat dissipation. In a conventional packaging technology, a substrate with a ceramic baseplate is usually used to implement functions of high thermal conductivity and insulation and pressure resistance, and plastic packaging is implemented by using an injection molding process.

In a plastic packaging process of a power module, a temperature change causes thermal stress inside the substrate, leading to warpage, and potentially resulting in adhesive overflow in the plastic packaging. Extruding the substrate can implement warpage suppression, but extrusion pressure may cause a crack in the ceramic baseplate, affecting structural reliability and product yield.

### SUMMARY

This application provides a power module, a power conversion device, and a lead frame. In an injection molding process, the power module can reduce a possibility of an undetectable micro crack generated in a ceramic baseplate under force, thereby improving product reliability, and helping improve production yield of the power module.

According to a first aspect, this application provides a power module, where the power module includes a substrate, an electronic element, and at least one mechanical part, the substrate includes a ceramic baseplate, and a first metal layer and a second metal layer that are disposed on two surfaces of the ceramic baseplate, both the electronic element and each mechanical part are disposed on a surface that is of the first metal layer and that is away from the ceramic baseplate, and brittleness of the mechanical part is less than brittleness of the ceramic baseplate; and in a direction perpendicular to the substrate, an orthographic projection of any mechanical part on the first metal layer does not overlap with an orthographic projection of the electronic element on the first metal layer.

In an injection molding packaging process of the power module, the mechanical part is configured to bear pressing of an ejector pin of an upper mold, and abutting the substrate against a lower mold can alleviate warpage of the substrate caused by a temperature change, and can further prevent a plastic injection material from intruding into a surface that is of the substrate and that faces the lower mold, thereby affecting heat dissipation. The brittleness of the mechanical part is less than the brittleness of the ceramic baseplate, and can better withstand pressure. The mechanical part bears the pressing of the ejector pin, so that the ejector pin can be prevented from directly contacting the substrate, thereby achieving force cushioning and even dispersion, protecting the ceramic baseplate included in the substrate, reducing a possibility of an undetectable micro crack generated in the ceramic baseplate under force, improving product reliability, and helping improve production yield of the power module.

In an embodiment, in the direction perpendicular to the substrate, a contact area between each mechanical part and the first metal layer is greater than a contact area on which the mechanical part presses against the ejector pin of the mold. Pressure applied by the ejector pin to the mechanical part can be transmitted and diffused in the mechanical part, so that pressure per unit area ultimately transmitted to the substrate is reduced, thereby reducing a risk of cracking caused by pressure on the ceramic baseplate in the substrate.

In an embodiment, the power module includes a lead frame, and the lead frame includes a plurality of pins; and each pin has a first connection segment and a second connection segment of an integrated structure, the first connection segment is disposed on the surface that is of the first metal layer and that is away from the ceramic baseplate, one end of the second connection segment is connected to the first connection segment, the other end of the second connection segment extends in a direction away from the first connection segment and is suspended relative to the first metal layer, and a part of the first connection segment forms the mechanical part. Process complexity and costs are reduced by forming the mechanical part using a part of the lead frame.

In an embodiment, in a direction parallel to the substrate and perpendicular to an arrangement direction of the first connection segment and the second connection segment, a width of the first connection segment is greater than a width of the second connection segment. An area of the first connection segment is increased to improve warpage control effect and pressure evenness effect, reducing the pressure per unit area transmitted to the substrate by using the mechanical part, and reducing a possibility of a crack generated in the ceramic baseplate under force.

In an embodiment, two ends of the at least one mechanical part are fastened to the first metal layer, and a middle part of the mechanical part protrudes in a direction away from the first metal layer. When the middle part of the mechanical part bears the pressing of the ejector pin, the middle part of the mechanical part is under pressure and is close to the first metal layer. A structure of the mechanical part is deformed to absorb a part of force, thereby reducing the force transmitted to the substrate through the two ends of the mechanical part, and achieving force cushioning.

In an embodiment, in the direction perpendicular to the substrate, at least one auxiliary stack layer is disposed on a surface that is of the at least one mechanical part and that is away from the first metal layer, and brittleness of each auxiliary stack layer is less than the brittleness of the ceramic baseplate. A thickness of the mechanical part is increased through stacking of the auxiliary stack layer, and the pressure cushioning effect of the mechanical part is enhanced when the mechanical part bears the pressing of the ejector pin. A material of the auxiliary stack layer may be the same as that of the mechanical part, to reduce process difficulty.

In an embodiment, the surface that is of the at least one mechanical part and that is away from the first metal layer is covered with a dielectric protective layer, and brittleness of the dielectric protective layer is less than the brittleness of the mechanical part, so that the pressure cushioning effect of the mechanical part can be optimized, and the mechanical part can be further protected to some extent.

In an embodiment, the dielectric protective layer includes at least one of an organic coating or a precured material and may be preformed during preparation of the mechanical part, thereby simplifying the process.

In an embodiment, the mechanical part is connected to the first metal layer by using solder, silver paste, or adhesive. When the mechanical part is welded to the first metal layer by using the solder, welding may be performed in a manner of brazing, laser welding, ultrasonic welding, or the like. When the mechanical part is bonded to the first metal layer by using the adhesive, bonding may be performed by using a process such as glue dispensing or coating. When the mechanical part is fastened to the first metal layer by using the silver paste, the connection may be implemented by using a silver sintering process. During preparation of a specific power module, a proper connection manner may be selected based on a material, a structure, and an implementation of the mechanical part.

In an embodiment, the at least one mechanical part is disposed at an edge or a corner of the first metal layer. A distribution position of the mechanical part relative to the substrate needs to be accordingly adjusted based on a specific structure of the power module.

In an embodiment, the power module includes a package body, and the package body wraps the substrate, the first metal layer, the electronic element, and each mechanical part.

According to a second aspect, this application provides a power conversion device, where the power conversion device includes a circuit board and any power module according to the first aspect, and the power module is electrically connected to the circuit board. Due to the more reliable structure of the power module, performance of the power conversion device is improved.

According to a third aspect, this application provides a powertrain, where the powertrain includes a control unit and a motor, and the control unit includes a plurality of power modules according to any one of the first aspect; and each power module is configured to convert electric energy transmitted from a power supply and output the electric energy to the motor. The power module has higher structural stability and reliability, thereby helping improve efficiency of the powertrain.

According to a fourth aspect, this application provides an electric vehicle. The electric vehicle includes a power battery, a wheel, and the powertrain according to the third aspect. A power conversion apparatus of the powertrain is configured to receive a direct current of the power battery, convert the direct current into an alternating current, and output the alternating current to a motor. The motor is in transmission connection to the wheel. The electric vehicle including the power module has better power performance.

According to a fifth aspect, this application provides a lead frame, where the lead frame includes a frame and a plurality of pins, the frame is configured to circumferentially surround a metal layer of a substrate, each pin has a first connection segment and a second connection segment of an integrated structure, the first connection segment is configured to be disposed on a surface of the metal layer of the substrate, the second connection segment is connected between the first connection segment and the frame, and the second connection segment is suspended relative to the metal layer of the substrate; and brittleness of the first connection segment is less than brittleness of a ceramic baseplate of the substrate. In an injection molding packaging process, a part of the first connection segment of the lead frame may be configured to bear pressing of an ejector pin of a mold, to prevent the ejector pin from directly contacting the substrate, thereby achieving force cushioning and even dispersion, protecting the ceramic baseplate included in the substrate, and reducing a possibility of an undetectable micro crack generated in the ceramic baseplate under force.

For technical effect that can be achieved in the second aspect to the fifth aspect, refer to corresponding effect descriptions in the first aspect. Details are not described herein again.

### BRIEF DESCRIPTION OF DRAWINGS

FIG. 1a is a diagram of an injection molding package structure of a conventional power module;
FIG. 1b is a diagram of a structure of a conventional power module;
FIG. 2a is a diagram of a power module according to an embodiment of this application;
FIG. 2b is a diagram of an injection molding package structure of a power module according to an embodiment of this application;
FIG. 3 is a diagram of a partial structure of a power module according to an embodiment of this application;
FIG. 4 is a cross-sectional diagram of a partial structure of a power module according to an embodiment of this application;
FIG. 5a is a cross-sectional diagram of a partial structure of a power module according to an embodiment of this application;
FIG. 5b is a cross-sectional diagram of a partial structure of a power module according to an embodiment of this application;
FIG. 6 is a cross-sectional diagram of a partial structure of a power module according to an embodiment of this application;
FIG. 7a is a cross-sectional diagram of a partial structure of a power module according to an embodiment of this application;
FIG. 7b is a cross-sectional diagram of a partial structure of a power module according to an embodiment of this application;
FIG. 8a is a diagram of a power module according to an embodiment of this application;
FIG. 8b is a diagram of an injection molding package structure of a power module according to an embodiment of this application;
FIG. 9 is a diagram of a partial structure of a power module according to an embodiment of this application;
FIG. 10a is a cross-sectional diagram of a partial structure of a power module according to an embodiment of this application;
FIG. 10b is a cross-sectional diagram of a partial structure of a power module according to an embodiment of this application;
FIG. 10c is a cross-sectional diagram of a partial structure of a power module according to an embodiment of this application;
FIG. 10d is a cross-sectional diagram of a partial structure of a power module according to an embodiment of this application;
FIG. 10e is a cross-sectional diagram of a partial structure of a power module according to an embodiment of this application;
FIG. 10f is a cross-sectional diagram of a partial structure of a power module according to an embodiment of this application;
FIG. 11 is a diagram of a partial structure of a power module according to an embodiment of this application;
FIG. 12 is a diagram of a structure of a power conversion device according to an embodiment of this application;
FIG. 13 is a diagram of a structure of an electric vehicle according to an embodiment of this application; and
FIG. 14 is a diagram of a working principle of a powertrain of an electric vehicle according to an embodiment of this application.

### Reference numerals:

1: substrate; 11: ceramic baseplate; 121: first metal layer; 122: second metal layer; 3: lead frame; 31: second connecting material; 300': frame; 300: pin; 301: first connection segment; 302: second connection segment; 4: mechanical part; 41: first connecting material; 42: dielectric protective layer; 43: auxiliary stack layer; 5: package body;
01: baseplate; 02: power electronic component; 031: upper mold; 032: lower mold; 04: package structure;
D: ejector pin; and Q: mold cavity.

### DESCRIPTION OF EMBODIMENTS

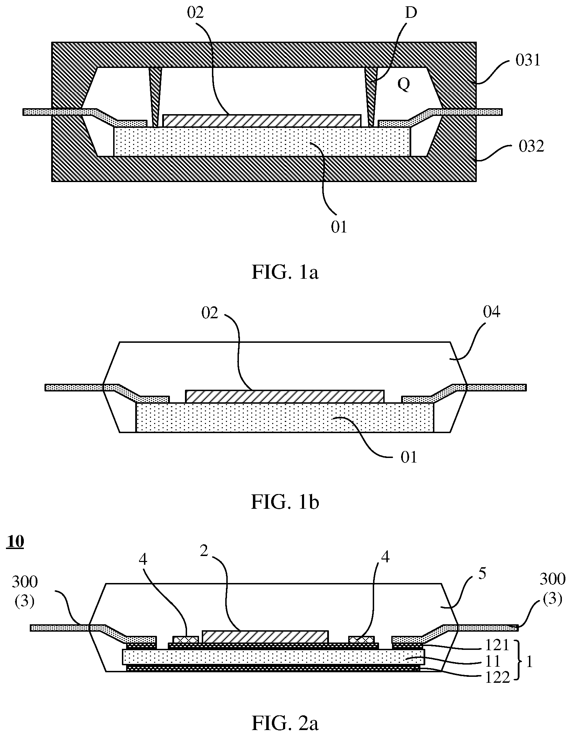

In the field of power electronics, a packaging technology may package an integrated circuit and a substrate as a whole by using an insulated plastic package material. Packaging of a power module is used as an example. As shown in FIG. 1a, a baseplate 01 disposed with a power electronic component 02 is placed in a mold cavity Q formed by enclosing an upper mold 031 and a lower mold 032, and a surface that is of the baseplate 01 and that is away from the power electronic component 02 presses against an inner wall of the lower mold 032. A liquid plastic package material is injected into the mold cavity Q, and the cured plastic package material can wrap the baseplate 01 and the integrated circuit to form a package structure 04 shown in FIG. 1b. A surface that is of the baseplate 01 and that faces the lower mold 032 needs to be exposed to the plastic package structure 04 after packaging, to facilitate heat dissipation of the power module. In an injection molding process, a temperature change causes thermal stress inside the baseplate 01, leading to warpage. As a result, the plastic package material overflows between the baseplate 01 and the lower mold 032, and heat dissipation performance of the power module is further affected. Therefore, the inner wall of the upper mold 031 includes an ejector pin D, where the ejector pin D may be used to press against the baseplate 01 in the injection molding process, and the ejector pin D may apply pressure to the baseplate 01 to weaken the warpage of the baseplate 01, and also prevent the baseplate 01 from detaching from the inner wall of the lower mold 032. However, when the insulating baseplate included in the baseplate 01 is made of a ceramic material, the ceramic material has low tensile strength, and poor plasticity and toughness, and pressing of the ejector pin D may crack the ceramic material of the baseplate 01, even affect insulation and pressure resistance performance of the baseplate 01, and also affect structural stability and reliability of the power module.

Based on this, embodiments of this application provide a power module, a power conversion device, and a lead frame. The power module can perform pressure protection on a substrate including a ceramic material in an injection molding process, thereby preventing the substrate from warping and not affecting structural stability of the ceramic material.

To make the objectives, technical solutions, and advantages of this application clearer, the following further describes this application in detail with reference to the accompanying drawings.

Terms used in the following embodiments are merely intended to describe specific embodiments, but are not intended to limit this application. Singular expressions "one", "a", "the", "the foregoing", "this", and "the one" used in this specification and the appended claims of this application are also intended to include expressions such as "one or more", unless otherwise specified in the context clearly.

Reference to "one embodiment", "some embodiments", or the like described in this specification means that one or more embodiments of this application include a specific feature, structure, or characteristic described with reference to the embodiments. Therefore, statements such as "in an embodiment", "in some embodiments", "in some other embodiments", and "in other embodiments" that appear at different places in this specification do not necessarily mean referring to a same embodiment. Instead, the statements mean "one or more but not all of embodiments", unless otherwise specifically emphasized in another manner. The terms "include", "comprise", "have", and their variants all mean "include but are not limited to", unless otherwise specifically emphasized in another manner.

FIG. 2a shows an example of a power module 10 according to an embodiment of this application. The power module 10 includes a substrate 1, an electronic element 2, and at least one mechanical part 4. The substrate 1 is configured to bear the electronic element 2 and each mechanical part 4. The substrate 1 includes a ceramic baseplate 11, a first metal layer 121, and a second metal layer 122. The ceramic baseplate 11 includes two opposite surfaces in a thickness direction. The first metal layer 121 and the second metal layer 122 are respectively disposed on the two surfaces of the ceramic baseplate 11. The substrate 1 is a sandwich-like structure. Both the electronic element 2 and each mechanical part 4 are disposed on a surface that is of the first metal layer 121 and that is away from the ceramic baseplate 11. A plurality of electrical components included in the electronic element 2 can be connected by using the first metal layer 121 to form a functional circuit. The second metal layer 122 is located on a surface that is of the ceramic baseplate 11 and that is away from the first metal layer 121. The first metal layer 121 and the second metal layer 122 are insulated by using the ceramic baseplate 11.

The ceramic baseplate 11 may be specifically aluminum oxide (Al₂O₃) ceramic, silicon nitride (Si₃N₄) ceramic, aluminum nitride (AlN) ceramic, and zirconia toughened alumina ceramic. The ceramic baseplate 11 has good insulation and pressure resistance properties, and prevents the first metal layer 121 from being electrically connected to the second metal layer 122. In an embodiment, the first metal layer 121 and the second metal layer 122 are respectively copper layers, and the substrate 1 may be a double-sided copper-clad plate. Specifically, the substrate 1 may be a direct bonded copper (DBC) ceramic substrate or a direct copper bonding (DCB) ceramic substrate. Alternatively, the substrate 1 may also be a metalized ceramic plate (AMB) substrate.

In an embodiment, the electronic element 2 is a combination of a plurality of power electronic components. The power electronic component herein includes an integrated circuit (IC) chip, an insulated gate bipolar transistor (IGBT), a silicon carbide power transistor, a silicon transistor, a metal-oxide-semiconductor field-effect transistor (MOSFET), a diode, and the like. The power electronic components included in the power module 10 can be electrically connected to form the functional circuit.

In an embodiment, the power module 10 further includes a lead frame 3 disposed on the first metal layer 121, and the lead frame 3 includes a plurality of pins 300. In a specific structure design, the power electronic components included in the electronic element 2 forms the functional circuit through circuit routing of the first metal layer 121, and is connected to an external circuit by using the plurality of pins 300 of the lead frame 3. The first metal layer 121 is divided into a plurality of metal sublayers as required, and adjacent metal sublayers are isolated from each other. Based on a circuit connection requirement, the power electronic components included in the electronic element 2 and the plurality of pins 300 of the lead frame 3 may be separately disposed at different metal sublayers. Each mechanical part 4 may be disposed at a same metal sublayer as the electronic element 2, or may be disposed at a same metal sublayer as the lead frame 3, or may be independently disposed at a metal sublayer.

In an embodiment, the power module 10 is plastically packaged by using an injection molding process to form a package body 5, and the package body 5 packages and fastens the substrate 1, the electronic element 2, and the lead frame 3. A surface that is of the second metal layer 122 of the substrate 1 and that is away from the ceramic baseplate 11 is exposed to the package body 5, and an end that is of each pin 300 of the lead frame 3 and that is away from the substrate 1 extends out of the package body 5. During injection molding of the power module 10, each mechanical part 4 is configured to bear pressing of an ejector pin D of a mold. Brittleness of the mechanical part 4 is less than brittleness of the ceramic baseplate 11, and can better withstand pressure.

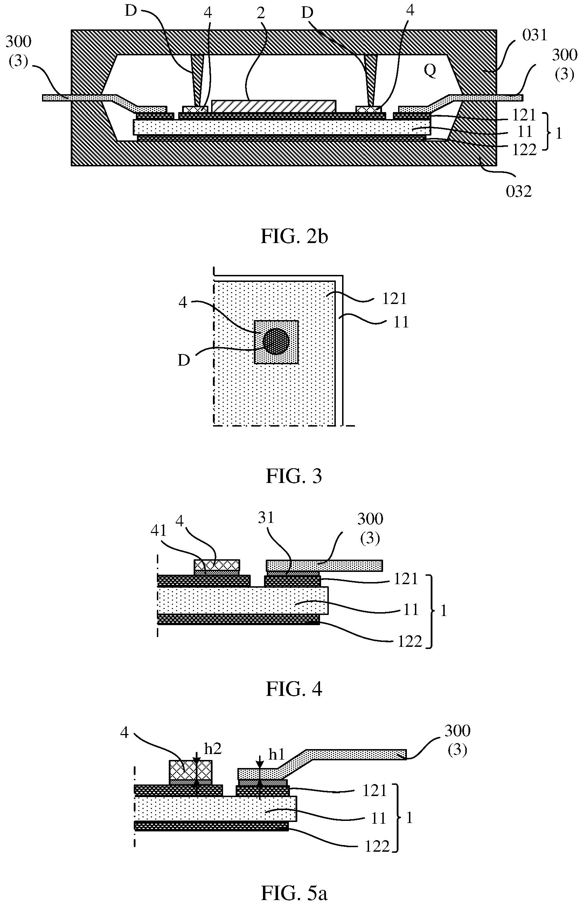

As shown in FIG. 2b, during injection molding packaging, the power module is placed in a mold cavity Q between an upper mold 031 and a lower mold 032, the second metal layer 122 of the substrate 1 is placed on an inner wall that is of the lower mold 032 and that faces the upper mold 031, the electronic element 2, the lead frame 3, and each mechanical part 4 are disposed on the first metal layer 121, and a part of each pin 300 of the lead frame 3 extends out of the mold cavity Q and is clamped between the upper mold 031 and the lower mold 032. The ejector pin D of the upper mold 031 extends towards the substrate 1 and presses against the mechanical part 4. The substrate 1 can be relatively fastened by using the ejector pin D of the upper mold 031 and the lower mold 032. In an injection molding process, warpage deformation of the substrate 1 under impact of a temperature change can be alleviated, and a warpage control requirement of the substrate 1 in the injection molding packaging process of the power module 10 can be met. Maintaining good flatness of the substrate 1 helps improve connection reliability of components of the power module 10, and can also improve production yield of the power module 10. Because the ejector pin D pressing against the mechanical part 4 can ensure that the second metal layer 122 of the substrate 1 maintains good contact with the lower mold 032, a liquid plastic injection material is less likely to enter between the second metal layer 122 and the inner wall of the lower mold 032. This prevents the plastic injection material from covering the surface of the second metal layer 122 and affecting heat dissipation of the power module 10.

The mechanical part 4 is interposed between the ejector pin D and the first metal layer 121 of the substrate 1, so that the ejector pin D does not directly apply pressure to the substrate 1. The mechanical part 4 can bear the pressure applied by the ejector pin D to the substrate 1, and can achieve pressure cushioning and even dispersion between the ejector pin D and the substrate 1, thereby alleviating an adverse impact of the pressure transmitted to the substrate 1 on the ceramic baseplate 11.

It should be understood that, the ejector pin D included in the upper mold 031 may be a fastened ejector pin, that is, the ejector pin D is fastened relative to the upper mold 031, and a position of the ejector pin D does not change in the injection molding process. Alternatively, the ejector pin D may be a resilient ejector pin, that is, the ejector pin D may move relative to the upper mold 031 by using a cylinder, a spring, and the like. In the injection molding process, with filling and curing of the plastic injection material in the mold cavity Q, the ejector pin D may gradually move out of the mold cavity Q.

In an embodiment, with reference to the power module 10 shown in FIG. 2a and FIG. 2b, a contact area between the ejector pin D and the mechanical part 4 is less than a contact area between the mechanical part 4 and the first metal layer 121 of the substrate 1, and pressure applied by the ejector pin D to the mechanical part 4 can be transmitted and diffused in the mechanical part 4 in a direction parallel to the substrate 1, so that pressure per unit area ultimately transmitted to the substrate 1 is reduced, thereby reducing a risk of cracking caused by pressure on the ceramic baseplate 11 in the substrate 1.

With reference to a top view of a partial structure of the power module 10 shown in FIG. 3, the mechanical part 4 and the corresponding ejector pin D are observed in a direction perpendicular to the substrate 1. An orthographic projection of the ejector pin D on the first metal layer 121 falls within a range of an orthographic projection of the mechanical part 4 on the first metal layer 121, and an orthographic projection of the ejector pin D on the mechanical part 4 falls within a surface contour that is of the mechanical part 4 and that faces the ejector pin D. A contact area between the mechanical part 4 and the first metal layer 121 of the substrate 1 is larger. Compared with the ejector pin D directly contacting the substrate 1, the mechanical part 4 can cover a larger area of the substrate 1, and therefore can affect a larger range of warpage of the substrate 1. As a result, warpage control effect of the mechanical part 4 on the substrate 1 is also better.

An orthographic projection of any mechanical part 4 on the first metal layer 121 does not overlap with an orthographic projection of the electronic element 2 on the first metal layer 121, and each mechanical part 4 avoids a structure of the electronic element 2 and a related circuit connection structure of the electronic element 2, to prevent impact on formation of the functional circuit.

A distribution position of the at least one mechanical part 4 relative to the substrate 1 needs to be accordingly adjusted based on a specific structure of the power module 10. For example, if a corner of the substrate 1 of the power module 10 is prone to warpage, at least one mechanical part 4 may be disposed at the corner of the substrate 1. Alternatively, if a side edge of the substrate 1 of the power module 10 is prone to warpage, at least one mechanical part 4 may be disposed on the edge of the substrate 1. Alternatively, if a central position of the substrate 1 of the power module 10 is prone to warpage, at least one mechanical part 4 may be disposed at the central position of the substrate 1. It should be understood that the mechanical part 4 is disposed on a surface that is of the first metal layer 121 of the substrate 1 and that is away from the ceramic baseplate 11.

In an embodiment, the power module 10 includes at least two mechanical parts 4, and different mechanical parts 4 are distributed at different positions, to bear pressing of the ejector pin D during injection molding packaging, and perform pressure cushioning protection on the ceramic baseplate 11 of the substrate 1 while alleviating warpage of the substrate 1.

The following describes a specific implementation of the mechanical part 4 by using a partial structure of the power module 10 as an example.

In an embodiment, as shown in FIG. 4, the mechanical part 4 is connected to the first metal layer 121 by using a first connecting material 41. The first connecting material 41 may be specifically solder, silver paste, or adhesive. When the mechanical part 4 is welded to the first metal layer 121 by using the solder, welding may be performed in a manner of brazing, laser welding, ultrasonic welding, or the like. When the mechanical part 4 is bonded to the first metal layer 121 by using the adhesive, bonding may be performed by using a process such as glue dispensing or coating. When the mechanical part 4 is fastened to the first metal layer 121 by using the silver paste, the mechanical part 4 may be fastened to the first metal layer 121 by using a silver sintering process.

In the structure shown in FIG. 4, one pin 300 of the lead frame 3 is used as an example. The pin 300 is fastened to the first metal layer 121 by using a second connecting material 31. The second connecting material 31 needs to balance functions of fastening and conductivity, to implement circuit interconnection between the lead frame 3 and the first metal layer 121. The second connecting material 31 may be solder or silver paste. Specifically, the pin 300 may be welded to the first metal layer 121 in a manner of brazing, laser welding, ultrasonic welding, or the like, or the pin 300 may be fastened to the first metal layer 121 by sintering the silver paste. When both the first connecting material 41 and the second connecting material 31 are solder, the types may be the same or may be different.

In an embodiment, as shown in FIG. 5a, in a direction perpendicular to the substrate 1, the at least one mechanical part 4 has a thick thickness, and pressure cushioning effect is improved by increasing the thickness. As a structural reference, a thickness h2 of the mechanical part 4 is greater than a thickness h1 of the pin 300. Specifically, the pin 300 may be bent and deformed in the direction perpendicular to the substrate 1, and the thickness h1 of the pin 300 is a thickness of a part where the pin 300 is connected to the first metal layer 121 of the substrate 1. It may be considered that, within a contour range of the first metal layer 121, the thickness h2 of the at least one mechanical part 4 is greater than the thickness h1 of the pin 300. It should be understood that the thickness of the pin 300 is also a thickness of the lead frame 3.

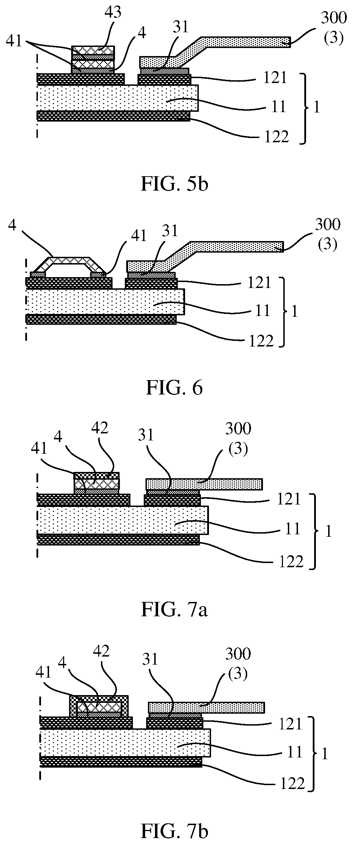

In an embodiment, as shown in FIG. 5b, in the direction perpendicular to the substrate 1, at least one auxiliary stack layer 43 is disposed on a surface that is of the at least one mechanical part 4 and that is away from the first metal layer 121, and the at least one auxiliary stack layer 43 is sequentially stacked on a surface that is of the first metal layer 121 and that is away from the ceramic baseplate 11. The thickness of the mechanical part 4 is increased through stacking of the auxiliary stack layer 43, and the pressure cushioning effect of the mechanical part 4 is enhanced when the mechanical part 4 bears the pressing of the ejector pin D. Any two adjacent auxiliary stack layers 43 and the auxiliary stack layers 43 and the mechanical part 4 may be connected by using the first connecting material 41. When the first connecting material 41 selects adhesive, good elasticity of the adhesive can improve the pressure cushioning effect of the mechanical part 4. A material, a thickness, and a size of each auxiliary stack layer 43 may be selected to be the same as or different from those of the mechanical part 4. When the auxiliary stack layer 43 and the mechanical part 4 are made of a same material, it may be considered that a plurality of mechanical parts 4 are stacked.

For the mechanical part 4 shown in FIG. 5a and FIG. 5b, pressure protection effect is improved by increasing a thickness of the mechanical part 4, and the thickness of the mechanical part 4 is increased, so that a longer cushioning path can be obtained in the direction perpendicular to the substrate 1 when pressure is transmitted to the mechanical part 4, thereby achieving better pressure protection.

In some embodiments, a shape of the mechanical part 4 is improved, so that the mechanical part 4 is in an arch or convex hull shape and has specific pre-compression elasticity. When the mechanical part 4 bears pressure of the ejector pin D, the mechanical part 4 can achieve pressure cushioning through structural deformation of the mechanical part 4. As shown in FIG. 6, two ends of the mechanical part 4 are fastened to the first metal layer 121, and a middle part of the mechanical part 4 protrudes in a direction away from the first metal layer 121. In this case, there is a gap between the middle part of the mechanical part 4 and the first metal layer 121, and the mechanical part 4 is arched. When the middle part of the mechanical part 4 bears the pressing of the ejector pin D, the middle part of the mechanical part 4 is under pressure and is close to the first metal layer 121. A structure of the mechanical part 4 is deformed to absorb a part of force, thereby reducing the force transmitted to the first metal layer 121 through the two ends of the mechanical part 4, and achieving force cushioning.

In some embodiments, as shown in FIG. 7a, in the direction perpendicular to the substrate 1, a surface that is of the mechanical part 4 and that is away from the first metal layer 121 is covered with a dielectric protective layer, and a structure is added to the surface of the mechanical part 4 to enhance cushioning effect of the mechanical part 4. Brittleness of the dielectric protective layer 42 is less than brittleness of the mechanical part 4, so that the pressure cushioning effect of the mechanical part 4 is optimized, and the mechanical part 4 can be further protected to some extent. The surface that is of the mechanical part 4 and that is away from the first metal layer 121 is a surface that is of the mechanical part 4 and that is for bearing pressing of the ejector pin D. The dielectric protective layer 42 may be further for pressure cushioning, thereby improving pressure protection effect. The dielectric protective layer 42 may be at least one of an organic coating or a precured material, and may be preformed during preparation of the mechanical part 4, thereby simplifying the process.

The organic coating is selected from materials with good elasticity after film formation, for example, a polyurethane coating, a propylene elastic coating, a silicone rubber coating, or an epoxy modified polyurethane coating. The precured material includes a resin material, a plastic material, and the like, and a precuring manner of the precured material includes but is not limited to ultraviolet curing, thermal curing, and the like. These dielectric protective layers 42 have better elasticity, can absorb more pressure, and further optimize pressure cushioning effect.

Based on the structure shown in FIG. 7a, in an embodiment, as shown in FIG. 7b, the dielectric protective layer 42 wraps a surface that is of the mechanical part 4 and that is away from the first metal layer 121 and a circumferential side surface. When the mechanical part 4 is fastened to the first metal layer 121 by using the first connecting material 41, the dielectric protective layer 42 may also wrap a circumferential side surface of the first connecting material 41.

It should be understood that various implementations of the mechanical part 4 provided in this embodiment of this application may be used in combination and conversion, to optimize the pressure cushioning effect of the ejector pin D in the injection molding process as much as possible. For example, the dielectric protective layer 42 is also disposed on the mechanical part 4 that has thickening processing, or a dielectric protective layer 42 is also disposed on the mechanical part 4 that has the auxiliary stack layer 43.

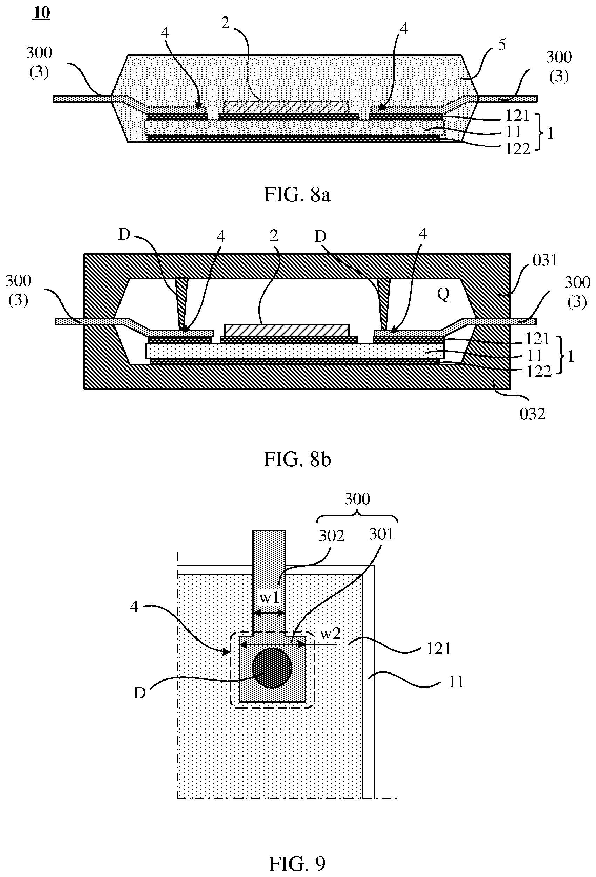

An embodiment of this application further provides a power module 10. As shown in FIG. 8a, a difference from the power module 10 shown in FIG. 2b lies in that a mechanical part 4 is formed by a part of a lead frame 3. As shown in FIG. 8b, in an injection molding packaging process of the power module 10, an ejector pin D abuts against a surface that is of the lead frame 3 and that is away from a first metal layer 121, and a part that is of the lead frame 3 and that is used for pressing of the ejector pin D forms the mechanical part 4. In this case, the lead frame 3 is used for circuit connection with the first metal layer 121, and also used for bearing the pressing of the ejector pin D. In an example, the lead frame 3 includes a plurality of pins 300, and the connecting part 4 is a part of one of the pins 300.

FIG. 9 is a top view of a partial structure of the power module 10. A pin 300 and a corresponding ejector pin D are observed in a direction perpendicular to a substrate 1. An orthographic projection of the ejector pin D on the first metal layer 121 falls within a range of an orthographic projection of the lead frame 3 on the first metal layer 121. For ease of understanding, a structure of the pin 300 is divided. The pin 300 includes a first connection segment 301 and a second connection segment 302. The first connection segment 301 and the second connection segment 302 have an integrated structure, that is, the first connection segment 301 and the second connection segment 302 can be prepared and formed in an integrated molding manner during preparation, thereby reducing process complexity and costs. The first connection segment 301 is disposed on a surface that is of the first metal layer 121 and that is away from a ceramic baseplate 11. One end of the second connection segment 302 is connected to the first connection segment 301, and the other end of the second connection segment 302 extends in a direction away from the first connection segment 301 and is suspended relative to the first metal layer 121. When the power module 10 is packaged, one end that is of the second connection segment 302 and that is away from the first connection segment 301 is exposed outside the package of the power module 10, and is configured to connect to another electrical component. The first connection segment 301 is configured to form the mechanical part 4, that is, a surface that is of the first connection segment 301 and that is away from the first metal layer 121 is configured to bear pressing of the ejector pin D. An orthographic projection of the ejector pin D on the pin 300 falls within a range of the first connection segment 301.

In an embodiment, in a direction parallel to the substrate 1 and perpendicular to an arrangement direction of the first connection segment 301 and the second connection segment 302, a width w1 of the first connection segment 301 is greater than a width w2 of the second connection segment 302, and the first connection segment 301 may cover a larger area of the substrate 1, thereby affecting warpage of the substrate 1 in a wider range, and providing better warpage control effect of the substrate 1. Increasing an area of the first connection segment 301 can further reduce pressure per unit area transmitted to the substrate 1 by using the mechanical part 4, and reduce a possibility of crack generated in the ceramic baseplate 11 under force.

It may be understood that, based on different function implementations of the power module 10, there are a plurality of implementations of a shape of the lead frame 3 and a connection position between the lead frame 3 and the first metal layer 121. A pin 300 of the lead frame 3 shown in FIG. 9 is merely an example of a structure. The solution in which a part of the lead frame 3 forms the mechanical part 4 provided in this embodiment of this application includes an implementation in which any part of the lead frame 3 forms the mechanical part 4, and a part of the lead frame 3 that can bear pressing of the ejector pin D may be considered as the part of the lead frame 3 forming the mechanical part 4.

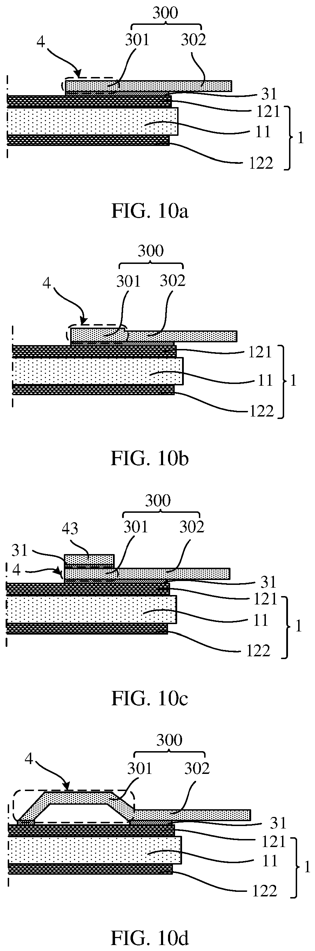

In an embodiment, as shown in FIG. 10a, the lead frame 3 is fastened to the first metal layer 121 by using a second connecting material 31. In this case, solder or silver paste having a conductive function is selected for the second connecting material 31.

In an embodiment, as shown in FIG. 10b, the first connection segment 301 of the pin 300 is thickened, so that a thickness of the lead frame 3 at the first connection segment 301 is greater than a thickness of the pin 300 at the second connection segment 302. The first connection segment 301 is configured to form the mechanical part 4, which is equivalent to an increase in a thickness of the mechanical part 4, thereby improving the cushioning effect.

In an embodiment, as shown in FIG. 10c, in a direction perpendicular to the substrate 1, at least one auxiliary stack layer 43 is disposed on a surface that is of the first connection segment 301 of the pin 300 and that is away from the first metal layer 121. The auxiliary stack layer 43 may also be connected to the first connection segment 301 by using the second connecting material 31, and the second connecting material 31 between the auxiliary stack layer 43 and the first connection segment 301 may be solder, silver paste, or adhesive. In this case, the auxiliary stack layer 43 may increase the thickness of the first connection segment 301, which is equivalent to increasing the thickness of the mechanical part 4, and can achieve good pressure cushioning.

In an embodiment, as shown in FIG. 10d, the first connection segment 301 of the pin 300 is in an arch or convex hull shape and has specific pre-compression elasticity. When the first connection segment 301 forms the mechanical part 4 to bear pressure of the ejector pin D, the mechanical part 4 can achieve pressure cushioning through structural deformation of the mechanical part 4.

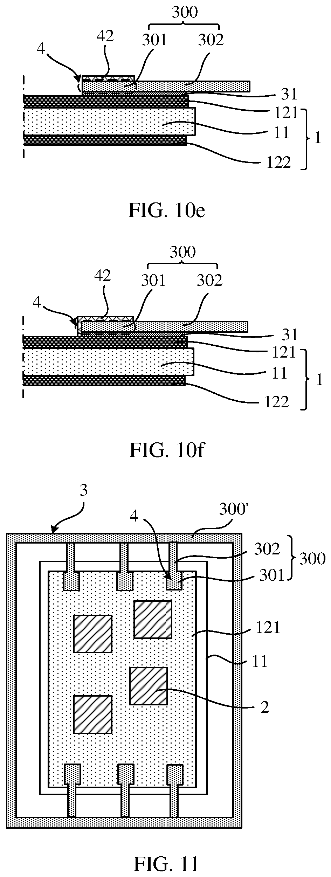

In an embodiment, as shown in FIG. 10e and FIG. 10f, a dielectric protective layer 42 is added to a surface that is of the first connection segment 301 of the pin 300 and that is away from the first metal layer 121. When the first connection segment 301 forms the mechanical part 4 to bear pressure of the ejector pin D, cushioning effect can be enhanced. As shown in FIG. 10e, the dielectric protective layer 42 may cover only the surface that is of the first connection segment 301 and that is away from the first metal layer 121, or may also cover a circumferential side surface of the first connection segment 301 as shown in FIG. 10f.

In conclusion, according to the power module 10 provided in this embodiment of this application, the mechanical part 4 is disposed on a surface on which the electronic element 2 is disposed on the substrate 1. In an injection molding packaging process of the power module 10, the mechanical part 4 is configured to bear pressing of an ejector pin D of an upper mold 031, and abutting the substrate 1 against a lower mold 032. On one hand, warpage of the substrate 1 caused by a temperature change can be alleviated, and on the other hand, a plastic injection material can be prevented from intruding into a surface that is of the substrate 1 and that faces the lower mold 032, thereby affecting heat dissipation. This helps improve production yield of the power module 10. The mechanical part 4 bears the pressing of the ejector pin D, so that the ejector pin D can be prevented from directly contacting the substrate 1, thereby achieving force cushioning and even dispersion, protecting the ceramic baseplate 11 included in the substrate 1, reducing a possibility of an undetectable micro crack generated in the ceramic baseplate 11 under force, and improving product reliability.

Based on the foregoing embodiment, an embodiment of this application further provides a lead frame 3. As shown in FIG. 11, the lead frame 3 includes a frame 300' and a plurality of pins 300. The frame 300' is configured to circumferentially surround a first metal layer 121 of a substrate 1, and there is a gap between the frame 300' and the first metal layer 121 of the substrate 1. For each pin, refer to FIG. 9 and FIG. 10a to FIG. 10f. The pin 300 includes a first connection segment 301 and a second connection segment 302. The first connection segment 301 is configured to be disposed on a surface of the first metal layer 121 of the substrate 1, and the second connection segment 302 is connected between the first connection segment 301 and the frame 300'. Using one of the pins 300 as an example, the first connection segment 301 of the pin 300 can bear pressing of an ejector pin D during injection molding packaging of a power module 10, thereby suppressing warpage of the substrate 1 by using the lead frame 3. The first connection segment 301 is interposed between the ejector pin D and the first metal layer 121 of the substrate 1, so that the ejector pin D does not directly apply pressure to the substrate 1. The first connection segment 301 can bear the pressure applied by the ejector pin D to the substrate 1, and can achieve pressure cushioning and even dispersion between the ejector pin D and the substrate 1, thereby alleviating an adverse impact of the pressure transmitted to the substrate 1 on the ceramic baseplate 11.

In an embodiment, an electronic element 2 of the power module 10 provided in this embodiment of this application can be connected to the first metal layer 121 of the substrate 1 to form a power conversion circuit. The power conversion circuit may be configured to implement one of circuit conversions of converting a direct current into an alternating current, converting an alternating current into a direct current, and converting a direct current into a direct current.

The power module is widely used in fields such as electric vehicles, new energy, photovoltaic, and wind power, and is configured to manage and control power transmission and conversion, to implement excellent performance such as a high voltage, a large current, a stable temperature, and low electromagnetic radiation. The main functions of the power module include voltage conversion, current control, and reversible conversion. The voltage conversion may convert a voltage of a power supply from one level to another level, and may meet a requirement of applying the power supply to different devices or systems. Current control controls the current to ensure that the current of the power supply is within an acceptable range and prevents the device or circuit from being damaged by overcurrent. Reversible conversion can convert a direct current into an alternating current or convert an alternating current into a direct current.

In the field of consumer electronics, the power module is mainly applied to a device such as a power adapter, an inverter, or a frequency converter. In the field of power energy, the power module is mainly applied to a device such as a solar inverter or a wind power converter. In the field of energy storage, the power module is mainly applied to a device such as an energy storage converter or a direct current converter. In the field of automobile electronics, the power module is mainly applied to a motor control unit, an on-board charger (OBC), a microcontroller unit (MCU), a generator control unit (GCU), and the like of an electric vehicle.

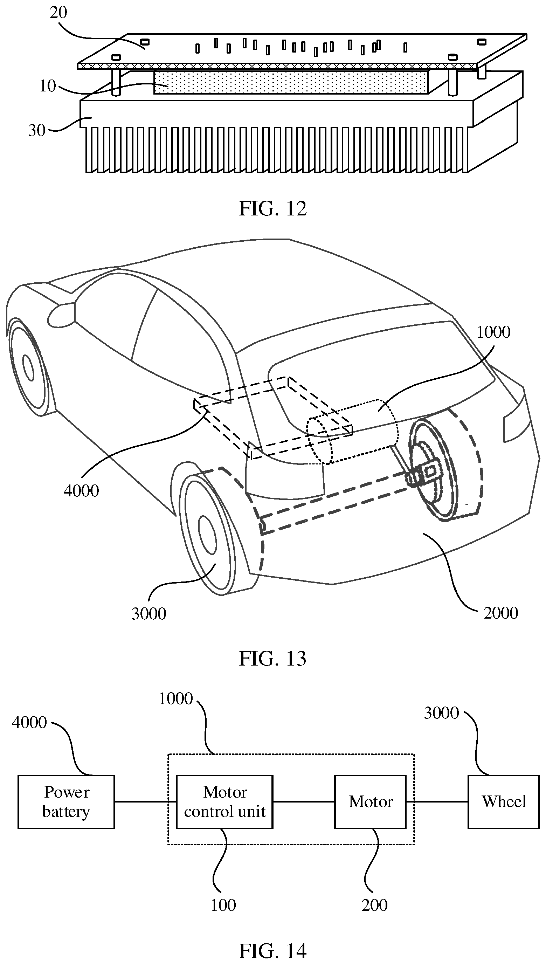

FIG. 12 is a diagram of a structure of a power conversion device according to an embodiment of this application. Refer to FIG. 12. The power conversion device includes a power module 10, a circuit board 20, and a heat sink 30. The power module 10 is electrically connected to the circuit board 20, and the heat sink 30 is in thermal conduction contact with the power module 10, to dissipate heat of the power module 10. In this application, the circuit board 20 may be, for example, a printed circuit board (PCB). The power module 10 is a core component for a photovoltaic inverter 100 to implement a power conversion function. The power module 10 may include a plurality of ports, such as input positive and negative ports, output positive and negative ports, and power supply positive and negative ports. These ports are separately electrically connected to the circuit board 20 by using pins, so that the circuit board 20 provides functions such as a current or voltage input, a current or voltage output, and power supply for the power module 10. Due to high reliability of the power module 10, performance of the power conversion device is improved.

For example, an embodiment of this application provides an electric vehicle shown in FIG. 13. The electric vehicle herein is a wheeled device driven or pulled by a power apparatus. In an implementation, the electric vehicle includes a special operation vehicle such as a passenger vehicle, a commercial vehicle, an engineering rescue vehicle, a sprinkler, a suction sewage truck, a cement mixer, a crane, or a medical vehicle. For example, the electric vehicle includes a pure electric vehicle (PEV/BEV), a hybrid electric vehicle (HEV), a range extended electric vehicle (REEV), a plug-in hybrid electric vehicle (PHEV), and the like.

As shown in FIG. 13, the electric vehicle includes a power battery 4000, a wheel 3000, a vehicle body 2000, and a powertrain 1000. The powertrain 1000, the power battery 4000, and the wheel 3000 are assembled on the vehicle body 2000.

As shown in FIG. 14, the powertrain 1000 includes a motor control unit 100 and a motor 200. The motor control unit 100 is configured to receive a direct current of the power battery 4000, and is configured to output an alternating current to the motor 200. The motor 200 is configured to receive the alternating current output by the motor control unit 100, and is configured to drive the wheel 3000 of the electric vehicle. In an embodiment, the powertrain 1000 integrates the motor 200 and the motor control unit 100 into one housing, so that integration of the powertrain 1000 can be increased, and volume and costs can be reduced. This helps implement a lightweight design of the powertrain 1000 and improve power density.

In this embodiment of this application, the motor control unit 100 includes a plurality of power modules 10. Each power module 10 may form a power conversion circuit, configured to receive direct current power supply from the power battery 4000, and output an alternating current to the motor 200 to drive the motor 200, thereby driving the electric vehicle to travel.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A power module, wherein the power module comprises a substrate, an electronic element, and at least one mechanical part, the substrate comprises a ceramic baseplate, and a first metal layer and a second metal layer that are disposed on two surfaces of the ceramic baseplate, both the electronic element and each mechanical part are disposed on a surface that is of the first metal layer and that is away from the ceramic baseplate, and brittleness of the mechanical part is less than brittleness of the ceramic baseplate; and
in a direction perpendicular to the substrate, an orthographic projection of any mechanical part on the first metal layer does not overlap with an orthographic projection of the electronic element on the first metal layer.

2. The power module according to claim 1, wherein the power module comprises a lead frame, and the lead frame comprises a plurality of pins; and
each pin has a first connection segment and a second connection segment of an integrated structure, the first connection segment is disposed on the surface that is of the first metal layer and that is away from the ceramic baseplate, one end of the second connection segment is connected to the first connection segment, the other end of the second connection segment extends in a direction away from the first connection segment and is suspended relative to the first metal layer, and a part of the first connection segment forms the mechanical part.

3. The power module according to claim 2, wherein in a direction parallel to the substrate and perpendicular to a connection direction between the first connection segment and the second connection segment, a width of the first connection segment is greater than a width of the second connection segment.

4. The power module according to any one of claims 1 to 3, wherein two ends of the at least one mechanical part are fastened to the first metal layer, and a middle part of the mechanical part protrudes in a direction away from the first metal layer.

5. The power module according to any one of claims 1 to **4,** wherein in the direction perpendicular to the substrate, at least one auxiliary stack layer is disposed on a surface that is of the at least one mechanical part and that is away from the first metal layer, and brittleness of each auxiliary stack layer is less than the brittleness of the ceramic baseplate.

6. The power module according to any one of claims 1 to 5, wherein the surface that is of the at least one mechanical part and that is away from the first metal layer is covered with a dielectric protective layer, and brittleness of the dielectric protective layer is less than the brittleness of the mechanical part.

7. The power module according to claim 6, wherein the dielectric protective layer comprises at least one of an organic coating or a precured material.

8. The power module according to any one of claims 1 to 7, wherein the mechanical part is connected to the first metal layer by using solder, silver paste, or adhesive.

9. The power module according to any one of claims 1 to 8, wherein the at least one mechanical part is disposed at an edge or a corner of the first metal layer.

10. A power conversion device, comprising a circuit board and the power module according to any one of claims 1 to 9, wherein the power module is electrically connected to the circuit board.

11. A lead frame, wherein the lead frame is configured to connect to a substrate of a power module;
the lead frame comprises a frame and a plurality of pins, and the frame is configured to circumferentially surround the substrate;
each pin has a first connection segment and a second connection segment of an integrated structure, the first connection segment is configured to be disposed on a surface of the substrate, and the second connection segment is connected between the first connection segment and the frame; and
brittleness of the first connection segment is less than brittleness of a ceramic baseplate of the substrate.
